(19) Europäisches Patentamt

European Patent Office

Office européen des brevets

(11) EP 0 922 793 A2

(12) **EUROPEAN PATENT APPLICATION**

(43) Date of publication:
16.06.1999 Bulletin 1999/24

(51) Int Cl.[6]: **C30B 33/00**, C30B 29/30

(21) Application number: 98309646.2

(22) Date of filing: 25.11.1998

(84) Designated Contracting States:
AT BE CH CY DE DK ES FI FR GB GR IE IT LI LU MC NL PT SE
Designated Extension States:
AL LT LV MK RO SI

(30) Priority: 25.11.1997 JP 32274797

(71) Applicant: NGK INSULATORS, LTD.
Nagoya City Aichi Pref. (JP)

(72) Inventors:
• Kawaguchi, Tatsuo
Hozumi-Cho, Motosu-Gun, Gifu Pref. (JP)

• Iwai, Makoto
Kasugai City, Aichi Pref. (JP)
• Imaeda, Minoru
Naka-Ku, Nagoya-City, Aichi Pref. (JP)

(74) Representative:
Paget, Hugh Charles Edward et al
MEWBURN ELLIS
York House
23 Kingsway
London WC2B 6HP (GB)

(54) **A method of processing a substrate made of a ferroelectric crystalline material**

(57) A substrate made of a ferroelectric crystalline material is processed by the steps of forming a desired proton-exchanged layer (2) in the substrate (1) by proton-exchanging a portion of the substrate, and selectively removing the proton-exchanged layer to form a recessed part (3) having a substantially semicircular sectional shape, wherein the proton-exchanging temperature is 120 to 180°C, In this way the desired shape is obtained.

FIG_Ia

EP 0 922 793 A2

*FIG_1b*

3

2

**Description**

Background of the Invention

(1) Field of the Invention:

This invention relates to a method of processing a substrate made of a ferroelectric crystalline material, and more particularly to a method of processing a substrate of a ferroelectric crystalline material suitable for an embedded-type optical waveguide element which can be used as a Second-Harmonic-Generation device using the Quasi-Phase-Matched type, an optical modulator, an optical switch and the like.

Related Art Statement:

The Second-Harmonic-Generation (SHG) device of the Quasi-Phase-Matched (QPM) type, in which a periodical polarizing inversion structure is formed on a $LiNbO_3$ or $LiTaO_3$ single crystal, is expected as a light source for a blue laser usable as an optical pickup or the like. This device can be widely used as an optical pickup or the like for the purposes of optical disk memory, medicine, photochemistry, and various optical measurements. An optical modulator or an optical switch, which uses an optical waveguide formed on a $LiNbO_3$ single crystal, is expected in the field of optical communication or information processing.

The optical waveguide device used as the SHG device, the optical modulator or the like is generally manufactured as follows.

A ferroelectric substrate of $LiNbO_3$ or the like is proton-exchanged by dipping it in a solution of benzoic acid or a solution of pyrophosphoric acid to form a desired proton-exchanged pattern, diffusing the protons into the substrate by annealing it at 300 to 400°C for 0.1 to 5 hours, whereby an optical waveguide is formed.

In another method, an optical waveguide is formed by evaporating a metal of Ti or the like onto a ferroelectric crystal of $LiNbO_3$ or the like to form a pattern, and thermally diffusing the Ti metal or the like into the substrate under heating at 900 to 1100°C for 4 to 40 hours,

However, in these methods, it has been difficult to form an optical waveguide having a stepped refractive index distribution with a large optically confining effect, so that it has been difficult to attain sufficiently large optical fiber coupling efficiency(the amount ratio of output light to input light in an optical waveguide device). Moreover, in the case of manufacturing an SHG device, light damaging resistance unfavorably was deteriorated, and conversion efficiency was decreased. Furthermore, prolonged heating is needed in the above method, so that the refractive index distribution is disadvantageously broader and the light confinement effect is diminished.

Thus, NGK Insulators, Ltd. invented a method of manufacturing a new optical waveguide device suitable for a SHG device or the like, and filed Japanese patent application No. 9-52,679 directed to this new optical waveguide device.

That is, a ferroelectric substrate made of $LiNbO_3$ or the like is proton-exchanged by dipping it in a solution of benzoic acid or a solution of pyrophosphoric acid, a proton-exchanged portion is selectively removed by wet-etching the thus obtained proton-exchanged layer with a solution of hydrofluoric acid or a solution of nitric acid to thereby form a recessed part having a substantially semicircular sectional shape, and thereafter forming a ferroelectric film, by liquid phase epitaxial method, on the substrate in which the recessed part is formed.

In this method, however, it was difficult to form the recessed part having the substantially semicircular sectional shape in the substrate, and the recessed parts formed in the above manner exhibited all a semi-elliptical sectional shape.

It is an object of this invention to provide a method of processing a substrate made of ferroelectric crystal to form a recessed part having a substantially semicircular sectional shape in the substrate.

Summary of the Invention:

This invention relates to a method of processing a substrate made of a ferroelectric crystalline material, comprising the steps of forming a desired proton-exchanged layer in the substrate by proton- exchanging a portion of the substrate, and selectively removing the proton-exchanged layer to form a recessed part having a substantially semicircular sectional shape, wherein a proton exchanging temperature is at 120 to 180°C.

According to the invented method of processing the substrate of the ferroelectric crystalline material, the recessed part having a substantially semicircular sectional shape can be formed in the substrate.

The reason is considered that diffusion coefficient generally depends on temperature and crystal orientation . Thus, in the case that the substrate of ferroelectric crystalline material is proton-exchanged at a lower temperature as in this invention, dependency of the proton diffusion coefficients upon the crystal orientation in X and Z directions of the substrate is well balanced with dependency of the diffusion coefficient upon the temperature, so that the dependency of the proton diffusion coefficient upon the crystal orientation in an X direction of the substrate is equal to that in a Z direction thereof.

As a result, since protons diffuse in a substantially semicircular sectional shape, the recessed part having the substantially semicircular sectional shape is formed by selectively removing the above proton-exchanged layer.

For shortening the processing time for proton-exchanging, the proton exchange temperature is preferably 130~180°C.

For obtaining high optical fiber coupling efficiency in the case of forming an optical waveguide device according to this invention, the exchange time of the protons is preferably 10~300 hours.

For forming the recessed part having a substantially perfect semicircular sectional shape in the substrate, the substrate has a proton diffusion coefficient $D_1$ in a direction parallel to a main surface of the substrate and a proton diffusion coefficient $D_2$ in a depth direction of the substrate normal to the main surface thereof which satisfy the following equation:

$$0.9 \leq (D_1/D_2)^{1/2} \leq 1.1,$$

when the desired proton-exchanged layer is formed by said proton-exchanging.

As pyrophosphoric acid has a large dissociation constant and a high proton exchange rare, the pattern of the proton-exchanged layer is preferably formed with pyrophosphoric acid after a protective mask pattern is formed on the substrate.

Having a large electro-optic constant and a non-linear optical constant, the ferroelectrical single crystal of $LiNb_{1-x}Ta_xO_3$ ($0 \leq X \leq 1$) is preferably used as the substrate.

Brief Description of the Drawings:

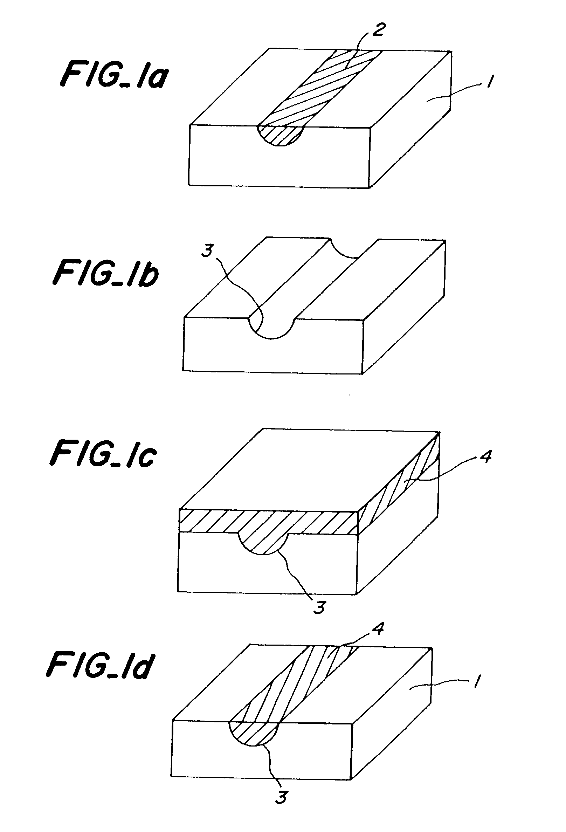

Figs. 1(a) through 1(d) shows the steps of manufacturing an embedded-type optical waveguide device having a substrate with a recessed part formed according to this invention, as viewed in section.

Detailed Description of the preferred Embodiments:

This invention will be described below in more detail with reference to Figs. 1(a) to 1(d), without limitation.

A substrate of ferroelectric crystalline material 1 is generally proton-exchanged by setting, on the substrate 1, a patterning mask having an opening corresponding to the part of the substrate 1 to be proton-exchanged and dipping the substrate 1 in the solution as a proton-exchanging source, whereby a proton exchanged layer 2 is formed on the main surface of the substrate 1 as shown Fig. 1(a).

The proton exchange temperature corresponds to the temperature of the solution as the proton exchanging source.

The upper limit of the proton exchange temperature must be 180°C, preferably 170°C, and more preferably 160°C to almost equalize the proton diffusion velocity in the X direction to that in the Z direction in the substrate 1.

The lower limit of the proton exchange temperature must be 120°C, preferably 130°C, and more preferably 140°C to diffuse effectively protons into the ferroelectric substrate 1.

The upper limit time required for proton exchanging, that is, the upper limit proton exchange time is preferably 300 hours, and more preferably 200 hours to prevent degradation of the patterning mask.

The lower limit time for proton exchange is preferably 10 hours and more preferably 40 hours to form a recessed part 3 having sufficient shape and dimension in the substrate 1 to further enhance the optical fiber coupling efficiency of the optical waveguide device.

In the case of proton-exchanging the substrate as mentioned above, to form the recessed part 3 having a more perfectly substantially semicircular sectional shape, the upper limit value of the half power $(D_1/D_2)^{1/2}$ of the ratio of the diffusion coefficient $D_1$ in a direction parallel to the main surface of the substrate 1 to the diffusion coefficient $D_2$ in a depth direction of the substrate normal to the main surface thereof, is preferably 1.1 and more preferably 1.05. The lower limit value of the half power is preferably 0.9 and more preferably 0.95 because of the same reason as the above upper value.

The opening width and the depth of the proton exchanged layer 2 thus formed are 1~50 μm and 0.5~25 μm, respectively, in this embodiment.

The material usable as the substrate 1 for example may be lithium niobate ($LiNbO_3$), lithium-tantalate ($LiTaO_3$), potassium lithium niobate (KLN), a lithium niobate-lithium tantalate solid solution ($LiNb_{1-x}Ta_xO_3$ ($0 \leq X \leq 1$)) and the like.

At least one element selected from magnesium (Mg), zinc (Zn), scandium (Sc), and indium (In) may be contained in the above material to improve the light damage resistance of the substrate 1.

Moreover, at least one element selected from neodymium (Nd), erbium (Er), thulium (Tm), holmium (Ho), dysprosium (Dy), praseodymium (Pr) and the like of the lanthanide series as the elements for laser oscillation may be contained in the above material of the substrate 1.

As the proton-exchanging source to be used for the proton-exchanging, pyrophosphoric acid, benzoic acid, octanoic acid, stearic acid, palmitic acid and the like may be used. Among the proton-exchanging source, pyrophosphoric acid may be preferably used, because it has a large dissociation constant and hardly evaporates. However any suitable proton-exchanging liquid may be used.

Subsequently as shown in Fig. 1(b), the proton-exchanged layer 2 formed by proton-exchanging is preferably dipped in the solution of hydrofluoric acid, nitric acid or the like, and selectively removed by wet-etching it to form the recessed part 3 having a substantially semicircular sectional shape on the substrate 1.

The proton-exchanged layer 2 is preferably removed by dipping the substrate 1 in the etching solution at 10~50°C for 0.1~10 hours.

The hydrofluoric acid solution, the nitric acid solution or the like employed at this time can be used in a concentration of 100% as in the case of the proton-exchanging source, or can be used as a water-diluted solution of 1~40% by diluting it with water.

Subsequently as shown in Fig. 1 (c), a film of ferroelectric crystalline material 4 is formed on the substrate 1 by the liquid phase epitaxial method to form an embedded-type optical waveguide device.

The film is formed at a film-forming temperature of about 900°C by the liquid phase epitaxial method so that the growth rate may be around 1 μm/min.

Sequently as shown in Fig. 1 (d), the most part of the film of the ferroelectric crystal except the recessed part 3 is removed by chemical-mechanical polishing and the embedded-type optical waveguide device can thereafter be obtained by optically polishing the ends of the substrate 1.

The material of the ferroelectric crystal usable for forming the optical waveguide must have a higher refractive index than that of the ferroelectric crystal usable for the substrate so that the light wave introduced from the outer side may effectively travel in the optical waveguide formed within the recessed part 3.

Concretely, lithium niobate, lithium tantalate, potassium lithium niobate, lithium niobate-lithium tantalate solid solution or the like can be used as the material of the optical waveguide. Among them, lithium niobate-lithium tantalate solid solution can be preferably used because the refractive index can be controlled by changing the ratio of niobium to tantalum.

Additionally at least one of the elements of the lanthanide series can be contained in the material of the optical waveguide as additional elements for laser oscillation as in the case of the substrate. Moreover at least one element selected from magnesium (Mg), zinc (Zn), scandium (Sc), and indium (In) may be contained in the above material to improve the light damage resistance of the substrate 1.

The lithium niobate-lithium tantalate solid solution is formed by contacting the substrate 1 to a melt, kept in a temperature range of 800 to 1,000°C, of lithium oxide ($Li_2O$), diniobium pentaoxide ($Nb_2O_5$), ditantalum pentaoxide ($Ta_2O_5$) and divanadium pentaoxide ($V_2O_5$) for 1~30 minute.

In the above, explanation is made of a case where the film of ferroelectric crystal for the formation of the optical waveguide is directly formed on the substrate in which the recessed part is formed. It may be that a first film of a ferroelectric single crystal is formed on the substrate in which a recessed part is formed, and a second film of ferroelectric crystal which is to form an optical waveguide and has larger refractive index than that of the first film be formed on the first film.

Examples:

The invention will be explained in more detail with reference to the following examples.

Experiment 1

A lithium niobate single crystal was used as a substrate. The tantalum film was formed in a thickness of about 50 nm on a Z-cut surface of the substrate by sputtering. Sequently, a mask pattern having an opening of width of about 0.5 μm was formed from the Ta film by photolithography and etching.

A solution of pyrophosphoric acid at 100% concentration was used as a proton-exchanging source. The substrate of the lithium niobate single crystal with the mask pattern was dipped in the solution at 170°C for 100 hour to form a proton-exchanged layer.

Thereafter, the substrate was dipped in a mixed solution of hydrofluoric acid and nitric acid (a mixed ratio 1: 2) at 40°C for 2 hour to selectively remove the proton- exchanged layer and form a pattern having a convex or concave shape.

The pattern had a ditch having a perfect semicircular sectional shape of which an opening half width (the half width of the opening) was 3.3 $\mu$ m with the depth of 3.3 $\mu$m. The half power $(D_1/D_2)^{1/2}$ of the ratio of the diffusion coefficient $D_1$ in a direction parallel to the main surface of the substrate to the diffusion coefficient $D_2$ in a depth direction normal to the main surface thereof was 1.0.

Experiment 2

Except that the opening width was about 1 $\mu$m and the dipping time in the pyrophophoric acid solution was 200 hours, and the dipping time in the mixed solution of hydrofluoric acid and nitric acid was 3 hours, this Experiment 2 was carried out in the same manner as in the Experiment 1.

The pattern with a convex or concave shape was of a ditch having a substantially semicircular sectional shape of which the opening half width was 5.5 $\mu$m with the depth of 5.4 $\mu$m. The half power $(D_1/D_2)^{1/2}$ was 1.01.

Experiment 3

Except that the temperature of the pyrophophoric acid solution was 150°C and the dipping time in the solution was 100 hours, and the dipping time in the mixed solution of hydrofluoric acid and nitric acid was 1 hour, this experiment was carried out as in Experiment 1.

The convex or concave pattern was of a ditch having perfect semicircular sectional shape of which the opening half width was 2.5 $\mu$m and the depth was 2.5 $\mu$m. The half power $(D_1/D_2)^{1/2}$ was 1.0.

Experiment 4

Except that the temperature of the pyrophophoric acid solution was 130°C and the dipping time in the solution was 200 hours, and the dipping time in the mixed solution of hydrofluoric acid and nitric acid was 1 hour, this experiment was carried out as in Experiment 1.

The pattern with a convex or concave shape was of a ditch having a substantially semicircular sectional shape of which the opening half width was 1.6 $\mu$m with the depth of 1.6 $\mu$m. The half power $(D_1/D_2)^{1/2}$ was 1.0.

Experiment 5

Except that the temperature of the pyrophophoric acid solution was 270°C and the dipping time in the solution was 2 hours, and the dipping time in the mixed solution of hydrofluoric acid and nitric acid was 2 hours, this experiment was carried out as in Experiment 1.

The pattern with a convex or concave shape was of a ditch a semi-elliptical sectional shape of which the opening half width was 4.7 $\mu$m with the depth of 3.4 $\mu$m. The half power $(D_1/D_2)^{1/2}$ was 1.4.

Experiment 6

Except that the temperature of the pyrophophoric acid solution was 260°C and the dipping time in the solution was 4 hours, and the dipping time in the mixed solution hydrofluoric acid and nitric acid was 2 hours, this experiment was carried out as in the Experiment 1.

The pattern like convex or concave was of a ditch having semi-elliptical sectional shape of which the opening half width was 5.5 $\mu$m and the depth was 4.1 $\mu$m. The half power $(D_1/D_2)^{1/2}$ was 1.35.

Experiment 7

Except that the temperature of the pyrophophoric acid solution was 200°C and the dipping time in the solution was 50 hours, and the dipping time in the solution mixed hydrofluoric acid and nitric acid was 3 hours, this experiment was carried out as in the Experiment 1.

The pattern like convex or concave was of a ditch having semi-elliptical sectional shape of which the opening half width was 6.0 $\mu$m and the depth was 4.7 $\mu$ m. The half power $(D_1/D_2)^{1/2}$ was 1.3.

Example 1~4 and Comparison Example 1~3

A film of a lithium niobate single crystal was formed on the substrate of a lithium niobate single crystal having the convex or concave pattern in each of the above Experiment 1~7 by the liquid phase epitaxial method using a melt of $Li_2O$, $Nb_2O_5$, and $V_2O_5$ at 900°C. Sequently, the film on the substrate except the recessed part thereof was removed by chemical-mechanical polishing, and the ends thereof were thereafter optically polished to form an optical waveguide on the substrate.

Optical fibers were optically connected to the input and output of the optical waveguide, respectively, to form an embedded-type optical waveguide device.

A laser beam of wavelength of 830 nm was introduced into the optical waveguide device from the input optical fiber and the power of the laser beam was measured at the output optical fiber to estimate the coupling efficiency of the embedded-type optical waveguide device.

The results were shown in the Table 1.

Table 1

|  | Substrate used | Proton exchange temperature (°C) | Proton exchange time (hour) | Opening half width of the recessed part ($\mu$m) | Depth of the recessed part ($\mu$m) | $(D_1/D_2)^{1/2}$ | Coupling efficiency |
|---|---|---|---|---|---|---|---|
| Example 1 | Experiment 1 | 170 | 100 | 3.3 | 3.3 | 1.0 | 90 |
| Example2 | Experiment2 | 170 | 200 | 5.5 | 5.4 | 1.0.1 | 90 |
| Example3 | Experiment3 | 150 | 100 | 2.5 | 2.5 | 1.0 | 90 |
| Example4 | Experiment4 | 130 | 200 | 1.6 | 1.6 | 1.0 | 90 |
| Comparative Example 1 | Experiment 5 | 270 | 2 | 4.7 | 3.4 | 1.4 | 45 |
| Comparative Example 2 | Experiment 6 | 260 | 4 | 5.5 | 4.1 | 1.35 | 50 |
| Comparative Example 3 | Experiment 7 | 200 | 50 | 6.0 | 4.7 | 1.3 | 50 |

As shown in the example 1 to 4, the substrate formed according to the method of processing the substrate of the ferroelectric crystalline material of this invention has the recessed part having a perfect semicircular sectional shape, so the embedded-type optical waveguide device in which the film of ferroelelctric crystal was formed on the substrate, has extremely large coupling efficiency.

On the other hand, as shown in Comparison Example 1 to 3, unlike the method of processing the substrate of ferroelelctric crystal of this invention, the substrate proton-exchanged at high temperature of 200°C and over according to the conventional method, has the recessed part having a semi-elliptical sectional shape, so the embedded-type optical waveguide device having the substrate does not have high coupling efficiency.

As above mentioned, using the method of processing the substrate of ferroelectric crystalline material according to this invention, the substrate of ferroelectric crystalline material can have a convex or concave pattern having a substantially semicircular sectional shape, so that in the case of forming an embedded-type optical waveguide device by forming a film of ferroelectric crystal on the substrate, it can have extremely high coupling efficiency.

While the invention has been particular shown and described with reference to preferred embodiments thereof, it will be understood by those skilled in the art that the foregoing and other changes in form and details can be made therein without departing from the spirit and scope of the invention.

**Claims**

1.  A method of processing a substrate made of a ferroelectric crystalline material, comprising the steps of forming a desired proton-exchanged layer in the substrate by proton- exchanging a portion of the substrate, and selectively removing the proton-exchanged layer to form a recessed part having a substantially semicircular sectional shape, wherein the proton-exchange temperature is 120 to 180°C.

2.  The processing method as claimed in claim 1, wherein the proton-exchange temperature is 130 to 180°C.

3.  The processing method as claimed in claim 1 or 2, wherein an exchange time of protons in proton-exchanging step is 10 to 300 hours.

4. The processing as claimed in any one of claims 1 to 3, wherein the substrate has a proton diffusion coefficient $D_1$ in a direction parallel to a main surface of the substrate and a proton diffusion coefficient $D_2$ in a depth direction of the substrate normal to the main surface thereof which satisfy the following equation:

$$0.9 \leq (D_1/D_2)^{1/2} \leq 1.1,$$

when the desired proton-exchanged layer is formed by said proton-exchanging.

5. The processing method as claimed in any one of claims 1 to 4, wherein the proton-exchanged layer is formed, by proton exchanging, with pyrophophoric acid after a protective mask pattern is formed on the ferroelectric crystalline substrate.

6. The processing method claimed in any one of claims 1 to 5, wherein the substrate of the ferroelectric crystalline material is formed from a single crystal having the composition:

$$(LiNb_{1-X}Ta_XO_3 \ (0 \leq X \leq 1)).$$

7. A method of manufacturing an embedded-type optical waveguide element, comprising the steps of preparing the ferroelectric crystalline substrate obtained by any one of claims 1 to 6, and growing, on the substrate, a film made of a ferroelectric crystalline material having a larger refractive index than that of the substrate by a liquid phase epitaxial method.

8. An embedded-type optical waveguide element formed according to the method of claim 7.

9. A method of processing a substrate made of a ferroelectric crystalline material, comprising the steps of forming a desired proton-exchanged layer in the substrate by proton- exchanging a portion of the substrate, and selectively removing the proton-exchanged layer to form a recessed part having a substantially semicircular sectional shape, wherein the substrate has a proton diffusion coefficient $D_1$ in a direction parallel to a main surface of the substrate and a proton diffusion coefficient $D_2$ in a depth direction of the substrate normal to the main surface thereof which satisfy the following equation:

$$0.9 \leq (D_1/D_2)^{1/2} \leq 1.1,$$

when the desired proton-exchanged layer is formed by said proton exchanging.

FIG_la

FIG_lb

FIG_lc

FIG_ld